# EUROPÄISCHE PATENTSCHRIFT

(11) **EP 0 508 179 B1**
(45) Veröffentlichungstag und Bekanntmachung des Hinweises auf die Patenterteilung: **16.07.1997**
(21) Anmeldenummer: 92104842.7
(22) Anmeldetag: 20.03.1992
(51) Int. Cl.: H01L 23/40, H01L 23/48, H01L 23/16

(54) **Schaltungsanordnung**
Circuit device
Dispositif de circuit

(30) Priorität: 08.04.1991 DE 4111247; 06.07.1991 DE 4122428
(43) Veröffentlichungstag der Anmeldung: 14.10.1992
(73) Patentinhaber: EXPORT-CONTOR Aussenhandelsgesellschaft mbH, D-90431 Nürnberg (DE)
(72) Erfinder:

(56) Entgegenhaltungen:
- EP-A- 0 097 087
- EP-A- 0 103 067
- EP-A- 0 340 959
- DE-A- 3 508 456
- DE-A- 3 616 494
- DE-A- 4 001 554
- GB-A- 2 167 228
- US-A- 4 769 744

## Beschreibung

Die Erfindung betrifft eine Schaltungsanordnung gemäß dem Oberbegriff des Anspruchs 1.

Eine derartige Schaltungsanordnung ist aus der DE 35 08 456 C2 bekannt.Dort ist die Trägerplatte, auf welcher mindestens ein zu kühlendes chipförmiges Bauelement vorgesehen ist, in ein Gehäuse eingeklebt und die Andrückvorrichtung mittels Justierschrauben und Zwischenstücken gebildet. Die Justierschrauben sind durch Verstrebungen des Gehäuses durchgeschraubt. Bei einer solchen Ausbildung der Schaltungsanordnung kann insbes. bei einer langzeitig gegebenen Wärmebelastung der Schaltungsanordnung nicht zuverlässig sichergestellt werden, daß der Anpreßdruck der Andrückvorrichtung konstant aufrechterhalten wird, weil es zu einem Nachgeben, z.B. Fließen, des Kunststoffmaterials des Gehäuses kommen kann. Desgleichen kann es infolge mechanischer Toleranzen der nicht nachgiebigen Zwischenstücke der Andrückvorrichtung zu einem Kontakt-Druckverlust kommen.

Aus der DE 29 42 401 A1 ist ein Halbleiterbauelement mit einer Andrückvorrichtung bekannt, die mindestens ein wärme- und formstabiles Montageelement in Form von Jochen und eine Plattfeder als elastisch nachgiebige Drückeinrichtung aufweist, die auf der dem Kühlbauteil in Gestalt eines wannenförmigen Bodens zugewandten Innenseite des Montageelementes vorgesehen ist, und die gegen das mindestens eine zu kühlende Bauelement und/oder in dessen Nachbarschaft elektrisch isoliert gegen die mindestens eine Trägerplatte drückt. Durch die Verwendung einer Plattfeder als nachgiebige Drückeinrichtung kann der Kontaktdruck eingestellt und konstant gehalten werden.

Die JP 1 310 566 A (Patent Abstracts of Japan, E-879, 1990, Vol. 14, Nr. 112) offenbart eine Halbleitervorrichtung mit einer zwischen einem Halbleiterchip und einer Kappe vorgesehenen Feder als nachgiebige Drückeinrichtung.

Aus der JP 63-226 952 A (Patent Abstracts of Japan, E-705, 1989, Vol. 13, Nr. 23) ist eine Halbleitervorrichtung mit einer Feder als nachgiebige Drückvorrichtung bekannt, wobei die Feder nicht unmittelbar auf einen Halbleiterchip sondern mittelbar über eine den Halbleiterchip bedeckende Isoliermasse gegen den Halbleiterchip drückt.

Die DE 36 28 556 C1 beschreibt eine Schaltungs- bzw. Halbleiteranordnung, bei welcher mindestens ein zu kühlendes chipförmiges Bauelement auf einer Trägerplatte angeordnet und in eine Isolierstoffmasse eingekapselt ist. Stromleiterteile des zu kühlenden chipförmigen Bauelementes sind wenigstens stellenweise als Kontaktstücke zur Druckkontaktierung ausgebildet. Die Stromleiterteile ragen auf der von der Trägerplatte abgewandten Seite des Bauelementes aus der Isolierstoffkapselung heraus. Diese Schaltungsanordnung ist mit einem Kühlbauteil und mit einer Kontaktplatte ausgebildet. Die Kontaktstücke sind vom Bauelement getrennt auf der Trägerplatte angeordnet. Die Druckkontaktierung der Kontaktstücke ist außerhalb der Isolierstoffkapselung vorgesehen und die Kontaktplatte ist allen Kontaktstücken gemeinsam.

Ein Leistungshalbleitermodul, bestehend aus einer beidseitig metallisierten Trägerplatte, die auf der Oberseite mit Bauelementen bestückt, in ein Kunststoffgehäuse eingesetzt und mit Vergießmasse abgedeckt ist, ist aus der DE 35 21 572 A1 bekannt. Dort wird vorgeschlagen, daß im Modul mindestens eine Stütze auf dem Trägerkörper oder einem Bauelement angeordnet ist, als eine erste Weichvergußmasse ein elastomerer Verguß vorgesehen ist, aus dem ein oberer Teil der Stütze bzw. Stützen herausragt, und als eine zweite Hartvergießmasse ein duroplastischer Verguß vorgesehen ist, der den oberen Teil der mindestens einen Stütze überdeckt und mit dem Gehäuse verbindet.

Aus der GB-A-2 167 228 ist eine Schaltungsanordnung mit einer Dichtungsscheibe als Drückvorrichtung bekannt. Die Dichtungsscheibe weist eine konstante Dicke auf.

Der Erfindung liegt die Aufgabe zugrunde, eine Schaltungsanordnung der eingangs genannten Art zu schaffen, die auch bei zeitlich wechselnder mechanischer und thermischer Belastung einen konstanten Anpreßdruck gewährleistet, und die ein einfaches mechanisches Zusammenbauen der Schaltungsanordnung erlaubt und die einfach herstellbar ist.

Diese Aufgabe wird bei einer Schaltungsanordnung der eingangs genannten Art durch die Merkmale des kennzeichnenden Teiles des Anspruchs 1 gelöst. Weiterbildungen der erfindungsgemäßen Schaltungsanordnung sind in den Unteransprüchen gekennzeichnet.

Durch das wärme- und formstabile Montageelement ergibt sich der Vorteil, daß auch bei langzeitig einwirkenden und/oder wechselnden mechanischen und/oder thermischen Belastungen ein Nachgeben bzw. Fließen des Materials für das Montageelement ausgeschlossen ist, so daß der Preßdruck der Andrückvorrichtung auf das mindestens eine zu kühlende Bauelement und/oder auf die mindestens eine Trägerplatte jederzeit zuverlässig aufrechterhalten und konstant bleibt. Das Montageelement besteht vorzugsweise aus Metall bzw. aus formstabilem Kunststoff. Das Montageelement und das Kühlbauteil können einfach ebenflächig plattenförmig ausgebildet sein; es ist jedoch auch möglich, bspw. das Kühlbauteil als mit Kühlrippen versehenen Kühlkörper auszubilden. Entsprechend kann selbstverständlich auch das Montageelement mit Kühlrippen versehen sein, um eine beidseitige und somit weiter verbesserte Kühlung der Trägerplatte zu gewährleisten. Insgesamt ist erfindungsgemäß eine Schaltungsanordnung relativ kleinen Volumens und großer Leistungsdichte realisierbar.

Bei der erfindungsgemäßen Schaltungsanordnung kann die Drückeinrichtung mindestens ein Federelement aufweisen. Bei dem/jedem Federelement handelt es sich bspw. um eine Schraubenfeder. Um bei einer derartig ausgebildeten Schaltungsanordnung Isolationsprobleme zuverlässig zu vermeiden, kann das/jedes Federelement mindestens an seinem vom Montageelement abgewandten Endabschnitt mit einer elektrischen Isolierung versehen sein. Diese Isolierung kann tablettenförmig, scheibenförmig, kappenförmig oder beliebig anders geformt sein.

Das Kissenelement ist an seiner vom Montageelement abgewandten Seite in mindestens annähernder Anpassung an die Profilierung der mindestens einen Trägerplatte mit Ausnehmungen und Erhebungen ausgebildet. Bei einer Schaltungsanordnung der zuletzt genannten Art ist eine Ausnehmung bzw. sind Ausnehmungen zur Fixierung und Justierung einer Trägerplatte bzw. von Trägerplatten relativ zueinander oder zum Kühlbauteil vorgesehen. Desgleichen sind bei einer solchen Schaltungsanordnung Ausnehmungen zur Fixierung und Justierung von starren loslösbaren Verbindungselementen relativ zu der mindestens einen Trägerplatte vorgesehen. Erhebungen können bei einer derartigen Schaltungsanordnung unmittelbar gegen die mindestens eine Trägerplatte oder gegen das mindestens eine an der entsprechenden Trägerplatte angeordnete Bauelement drücken.

Die erfindungsgemäße Schaltungsanordnung weist außerdem die besonderen Vorteile auf, daß sie sehr montage- und reparaturfreundlich ist, weil es problemlos möglich ist, eine schadhafte Trägerplatte durch eine ungebrauchte neue bzw. funktionstüchtige Trägerplatte zu ersetzen, wonach die Andrückvorrichtung wiederum am Kühlbauteil befestigt werden kann. Das erfolgt bspw. durch Schraub- und/oder Klemmverbindungen. Vorteilhaft kann es sein, das Montageelement der Andrückvorrichtung mit dem Kühlbauteil mittels federnder Verbindungselemente wie Federscheiben o.dgl. zu verbinden, wodurch jegliches Nachgeben zwischen diesen Teilen ausgeglichen werden kann.

Eine gegen Einflüsse von außen zuverlässig geschützte Schaltungsanordnung ergibt sich, wenn mindestens eine Erhebung als in sich geschlossener Dichtungswulst ausgebildet ist. Damit können einzelne Bauelemente bzw. einzelne Trägerplatten oder die gesamte Schaltungsanordnung abgedichtet und geschützt werden.

Um eine zuverlässige Anpreßkraft zu gewährleisten, mit welcher die mindestens eine Trägerplatte gegen das Kühlbauteil gedrückt wird, um einen guten, großflächigen Wärmekontakt von der Trägerplatte zum Kühlbauteil zu gewährleisten, ist es vorteilhaft, wenn das Montageelement auf seiner dem Kühlbauteil zugewandten Innenseite eine Profilierung aufweist, die mindestens annähernd an die Profilierung des mindestens einen Kissenelementes angepaßt ist.

Bei der erfindungsgemäßen Schaltungsanordnung kann das mindestens eine, auf der Trägerplatte angeordnete, zu kühlende Bauelement vollständig mit einer Weichvergußmasse bedeckt sein. Bei dieser Weichvergußmasse handelt es sich bspw. um eine Silikongummimasse.

Eine weiter verbesserte Schaltungsanordnung ergibt sich, wenn das/jedes Kissenelement von mindestens einem zugehörigen Brückenelement mindestens einseitig begrenzt ist, das aus wärme- und formstabilem Material besteht und mittels Erhebungen auf das mindestens eine zu kühlende Bauelement und/oder gegen die mindestens eine Trägerplatte drückt und diese fixiert. Auf diese Weise bleibt auch bei hohen Betriebstemperaturen jederzeit ein bestimmter Anpreßdruck gegen die Trägerplatte bzw. das Kühlbauteil gewährleistet.

Durch das mindestens eine wärme- und formstabile Brückenelement werden die aus elastischem Material bestehenden Teile des Kissenelementes, die auf die entsprechenden Elemente bzw. Teile der Schaltungsanordnung drücken, von diesen thermisch isoliert und mechanisch begrenzt, so daß sich eine bspw. temperaturbedingte plastische Verformung des Materials des Kissenelementes nicht in einer Verringerung des vorgegebenen Anpreßdruckes niederschlägt.

Desweiteren kann durch eine entsprechende Gestaltung des Brückenelementes, angepaßt an die Profilierung der zu drückenden Elemente und/oder Teile der Schaltungsanordnung der Anpreßdruck so auf diese Schaltungsteile geleitet werden, daß ein guter Wärmekontakt und eine gute mechanische Befestigung der Teile zur Kühlplatte gegeben ist. Ferner kann das mindestens eine Brückenelement so gestaltet sein, daß es die Schaltungsteile der Schaltungsanordnung gegenseitig justiert und fixiert. Das/jedes Brückenelement kann hierbei aus elektrisch isolierendem Material bestehen. Bestehen einzelne Brückenelemente aus elektrisch leitendem Material, dann können damit auch elektrische Verbindungen zwischen den Schaltungsteilen hergestellt werden.

Bei den Brückenelementen kann es sich um voneinander unabhängige getrennte Elemente handeln, wodurch eine ausgezeichnete Formanpassung an die Gegebenheiten der Schaltungsanordnung erzielbar ist. Als voneinander unabhängige, getrennte Elemente ausgebildete Brückenelemente bedingen jedoch einen gewissen Montageaufwand bei der Herstellung der Schaltungsanordnung, weshalb es zweckmäßig sein kann, wenn die Brückenelemente miteinander zu einer Einheit verbunden sind. Hierbei können die Brückenelemente gleichsam ein starres Gebilde darstellen oder miteinander mittels flexibler Verbindungsorgane verbunden sein, um eine gute Anpassung an die Gegebenheiten der entsprechenden Schaltungsanordnung zu gewährleisten. Demselben Zweck dient es, wenn das mindestens eine Brückenelement an seiner dem Kühlbauteil zugewandten Seite mit einer an die Profilierung der Schaltungsanordnung angepaßten Oberflächenkontur ausgebildet ist.

In einem vergrößerten Maßstab angedeutete Ausführungsbeispiele der erfindungsgemäßen Schaltungsanordnung sind in der Zeichnung dargestellt und werden nachfolgend beschrieben. Es zeigen:
- Fig. 1: einen Schnitt durch eine erste Ausführungsform der Schaltungsanordnung,
- Fig. 2: einen der Fig. 1 ähnlichen Schnitt durch eine zweite Ausführungsform der Schaltungsanordnung,
- Fig. 3: einen den Figuren 1 und 2 ähnlichen Schnitt durch eine dritte Ausführungsform der Schaltungsanordnung, und
- Fig. 4: teilweise aufgeschnitten eine vierte Ausführungsform der Schaltungsanordnung.

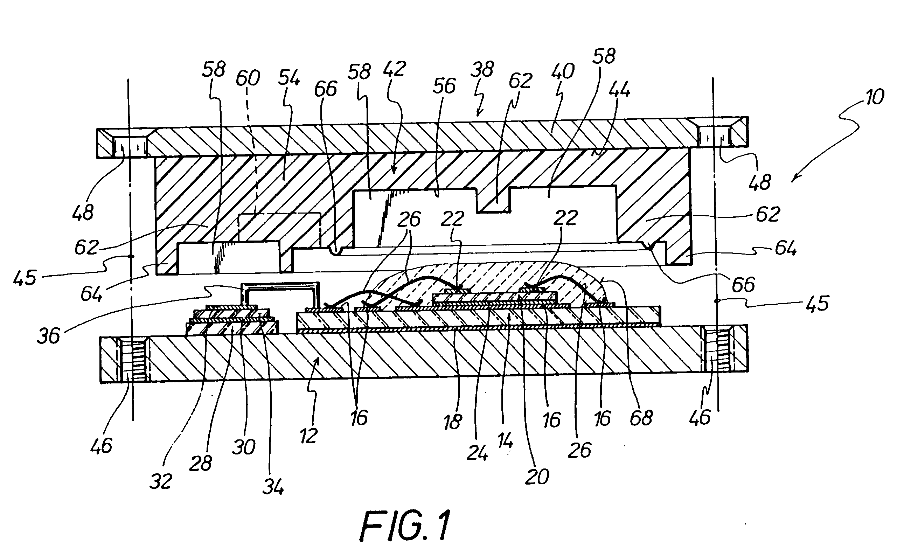

Fig. 1 zeigt in einer Schnittdarstellung eine Schaltungsanordnung 10 mit einem Kühlbauteil 12. Das Kühlbauteil 12 ist bei dem in dieser Figur gezeichneten Ausführungsbeispiel der Schaltungsanordnung 10 als einfache Platte ausgebildet. Auf dem Kühlbauteil 12 ist eine Trägerplatte 14 angeordnet, die mit Kontaktflächen 16 und auf der von den Kontaktflächen 16 abgewandten Unterseite mit einer Metallschicht 18 versehen ist, um zwischen der Trägerplatte 14 und dem Kühlbauteil 12 eine gute Wärmeleitung zu gewährleisten.

Auf der Trägerplatte 14 ist ein chipförmiges Bauelement 20 angeordnet, das Kontakte 22 und 24 aufweist. Der Kontakt 24 ist mit einer zugehörigen Kontaktfläche 16 der Trägerplatte 14 verbunden. Die Kontakte 22 des chipförmigen Bauelementes 20 sind mittels flexibler Verbindungselemente 26, z.B. mittels Bonddrähten, mit zugehörigen Kontaktflächen 16 der Trägerplatte 14 elektrisch leitend verbunden.

Von der Trägerplatte 14 getrennt ist auf dem Kühlbauteil 12 ein Substrat 28 mit Anschlüssen 30 und 32, die voneinander mittels einer Isolierung 34 elektrisch isoliert sind, gezeichnet. Ein starres Verbindungselement 36 in Form eines Bügels ist dazu vorgesehen, zwischen der entsprechenden Kontaktfläche 16 an der Trägerplatte 14 und dem entsprechenden Anschluß 32 am Substrat 28 eine elektrisch leitende Verbindung herzustellen.

Die Schaltungsanordnung 10 weist eine Andrückvorrichtung 38 mit einem Montageelement 40 und einer Drückeinrichtung 42 auf. Die Drückeinrichtung 42 ist an der dem Kühlbauteil 12 zugewandten Unter- bzw. Innenseite 44 des Montageelementes 40 vorgesehen. Das Montageelement 40 besteht bspw. aus Metall und ist wärme- und formstabil.

Das Kühlbauteil 12 und das Montageelement 40 sind miteinander mechanisch verbunden, was durch die dünnen strichpunktierten Linien 45 zwischen den axial fluchtenden Durchgangslöchern 46, 48 angedeutet ist. Diese mechanische Verbindung kann durch (nicht gezeichnete) Federelemente erfolgen, durch welche ein bestimmter Anpreßdruck aufrechterhalten wird. Bei diesen Federelementen handelt es sich bspw. um an sich bekannte Federscheiben o.dgl.

In Fig. 1 ist eine Schaltungsanordnung 10 im nicht zusammengebauten Zustand angedeutet, bei welcher die Andrückvorrichtung 38 bzw. die Drückeinrichtung 42 der Andrückvorrichtung 38 ein Kissenelement 54 aus einem elektrisch isolierenden und elastisch nachgiebigen Material aufweist. Das Kissenelement 54 ist an seiner vom Montageelement 40 abgewandten Seite 56 in mindestens annähernder Anpassung an die Höhenprofilierung der Trägerplatte 14, des auf der Trägerplatte 14 angeordneten chipförmigen Bauelementes 20 bzw. der starren Verbindungselemente 36 zwischen der Trägerplatte 14 und dem Substrat 28 mit Ausnehmungen 58, 60 und mit Erhebungen 62 und 64 ausgebildet. Die Ausnehmungen 58, d.h. die in sich zusammenhängende Ausnehmung 58 dient insbes. zur Justierung der Trägerplatte 14 in bezug auf das Kühlbauteil 12 während die/jede Ausnehmung 60 zur Justierung eines zugehörigen starren Verbindungselementes 36 dient. Mit Hilfe der Andrückvorrichtung 38 wird also nicht nur die Trägerplatte 14 mit dem chipförmigen Bauelement 20 sowie das Substrat 28 mit den Anschlüssen 30 und 32 genau passend am Kühlbauteil 12 festgelegt, sondern gleichzeitig mit den starren Verbindungselementen 36 der entsprechende elektrisch leitende Kontakt zwischen Kontaktflächen 16 an der Trägerplatte 14 und bspw. dem Anschluß 32 am Substrat 28 hergestellt.

Die Erhebungen 62 dienen zum Andrücken der Trägerplatte 14 entweder unmittelbar oder über das chipförmige Bauelement 20 am Kühlbauteil 12. Eine in sich geschlossene umlaufende Erhebung 66 ist als Dichtungswulst ausgebildet, ebenso wie ein äußerer umlaufender Dichtungswulst 64. Eine Weichvergußmasse 68 bedeckt das auf den Trägerkörper 14 befestigte chipförmige Bauelement 20.

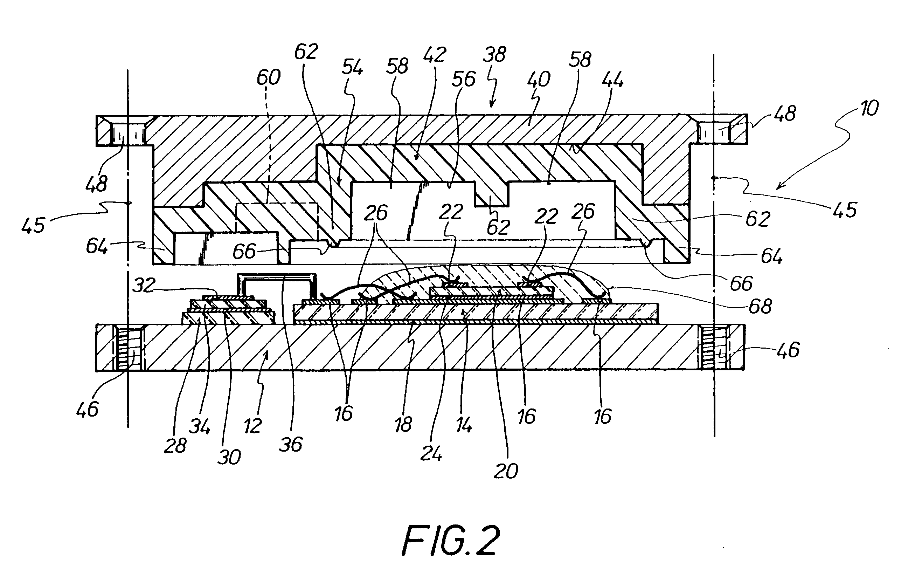

In Fig. 1 ist eine Schaltungsanordnung 10 im geöffneten Zustand dargestellt, bei welcher das Montageelement 40 der Andrückvorrichtung 38 als ebene Platte ausgebildet ist. Demgegenüber ist in Fig. 2 eine Ausführungsform der Schaltungsanordnung 10 gezeichnet, bei welcher das Montageelement 40 auf seiner dem Kühlbauteil 12 zugewandten Innenseite 44 eine Profilierung aufweist, die mindestens annähernd an die Profilierung 56 des Kissenelementes 54 der Andrückvorrichtung 38 angepaßt ist. Im übrigen ist die Schaltungsanordnung 10 gemäß Fig. 2 ähnlich ausgebildet wie die in Fig. 1 gezeichnete Ausführungsform der Schaltungsanordnung 10, so daß es sich erübrigt, alle Einzelheiten der Schaltungsanordnung 10 in Verbindung mit Fig. 2 noch einmal detailliert zu beschreiben. Gleiche Einzelheiten sind in den Figuren 1 und 2 mit denselben Bezugsziffern bezeichnet.

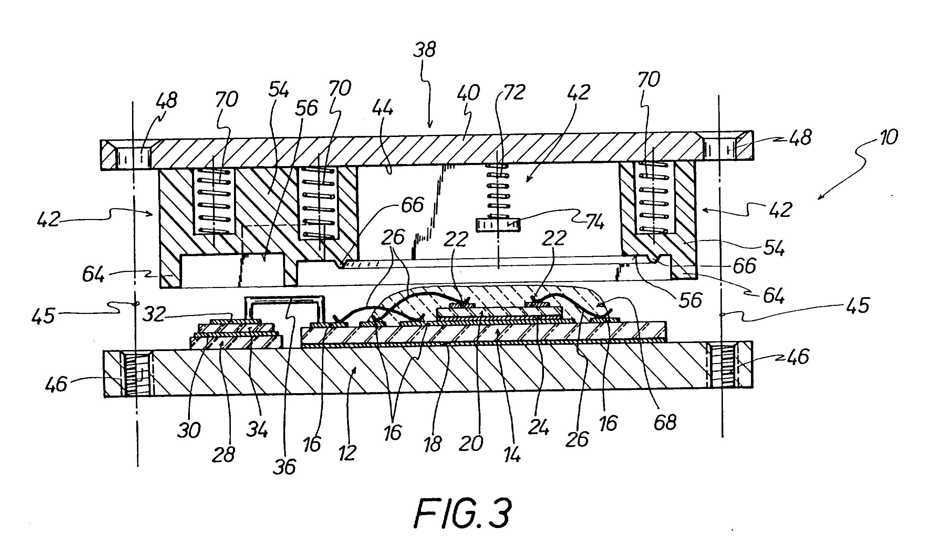

Fig. 3 zeigt eine Ausführungsform der Schaltungsanordnung 10, die sich von den Schaltungsanordnungen 10 gemäß Fig. 1 oder 2 insbes. dadurch unterscheidet, daß die Drückeinrichtung 42 der Andrückvorrichtung 38 Federelemente 70 und 72 aufweist. Die Federelemente 70 sind mit einem Kissenelement 54 kombiniert, während das Federelement 72 mit einer elektrischen Isolierung 74 in Form einer Scheibe, Kappe o.dgl. kombiniert ist. Die Federelemente 70 und 72 sind an der Innenseite 44 des Montageelementes 40 befestigt. Entsprechend ist das Kissenelement 54 an der Innenseite 44 des Montageelementes 40 befestigt. Im übrigen ist die Schaltungsanordnung 10 gemäß Fig. 3 ähnlich ausgebildet wie die Schaltungsanordnungen 10 gemäß Figuren 1 und 2, so daß es sich erübrigt, auf alle diese Einzelheiten, die in Fig. 3 mit denselben Bezugsziffern bezeichnet sind, wie in den Figuren 1 und 2, noch einmal detailliert einzugehen.

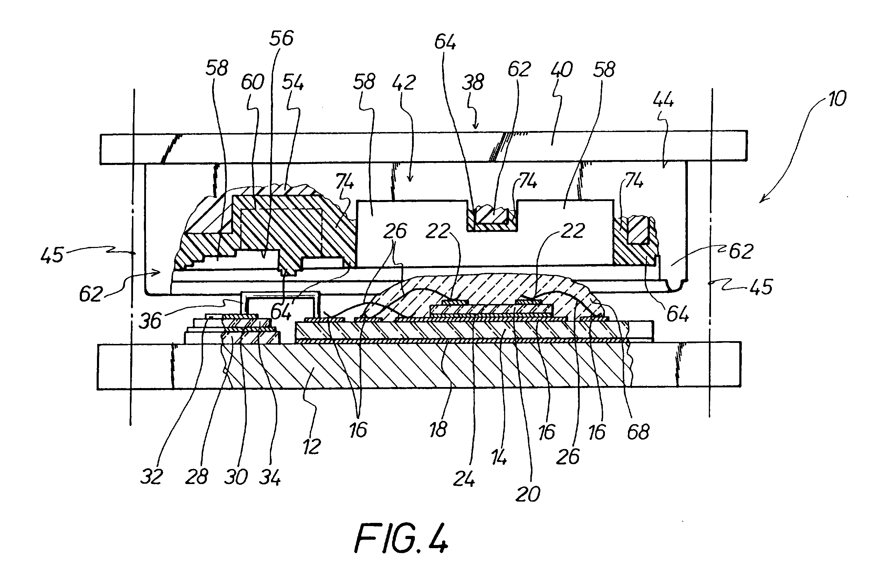

Fig. 4 zeigt in einem vergrößerten Maßstab teilweise aufgeschnitten eine Schaltungsanordnung 10 mit einem Kühlbauteil 12. Das Kühlbauteil 12 ist als ebene Metallplatte ausgebildet. Selbstverständlich wäre es auch möglich, das Kühlbauteil 12 mit Kühlrippen auszubilden. Auf dem Kühlbauteil 12 ist eine Trägerplatte 14 aus elektrisch isolierendem Material angeordnet, die Kontaktflächen 16 aufweist, die auf der Oberseite der Trägerplatte 14 voneinander beabstandet vorgesehen sind. Auf der von den Kontaktflächen 16 abgewandten Unterseite ist die Trägerplatte 14 mit einer Metallschicht 18 versehen, um zwischen der Trägerplatte 14 und dem Kühlbauteil 12 eine gute Wärmeleitung zu gewährleisten. Auf der Trägerplatte 14 ist ein chipförmiges Bauelement 20 angeordnet, bei dem es sich insbes. um ein Halbleiterbauelement handelt. Das chipförmige Bauelement 20 weist Kontakte 22 und 24 auf. Der Kontakt 24 ist mit einer zugehörigen Kontaktfläche 16 der Trägerplatte 14 kontaktiert. Die Kontakte 22 auf der Oberseite des chipförmigen Bauelementes 20 sind mittels flexibler Verbindungselemente 26 mit zugehörigen Kontaktflächen 16 der Trägerplatte 14 elektrisch leistend verbunden. Bei den flexiblen Verbindungselementen 26 handelt es sich bspw. um Bonddrähte.

Von der Trägerplatte 14 räumlich getrennt ist auf dem Kühlbauteil 12 ein Substrat 28 angeordnet, das mit Anschlüssen 30 und 32 ausgebildet ist, die voneinander mittels einer Isolierung 34 elektrisch isoliert sind. Ein starres Verbindungselement 36 dient dazu,zwischen der entsprechenden Kontaktfläche 16 auf der Trägerplatte 14 und dem zugehörigen Anschluß 32 auf dem Substrat 28 eine elektrisch leitende Verbindung herzustellen. Das starre Verbindungselement 36 ist z.B. als Kontaktbügel ausgebildet.

Die Schaltungsanordnung 10 weist eine Andrückvorrichtung 38 mit einem Montageelement 40 und einer Drückeinrichtung 42 auf. Das Montageelement 40 besteht bspw. aus Metall und ist als Platte ausreichender Wanddicke ausgebildet, um eine entsprechende Formstabilität zu gewährleisten. Die Drückeinrichtung 42 ist an der dem Kühlbauteil 12 zugewandten Unterseite 44 des Montageelementes 40 vorgesehen.

Das Kühlbauteil 12 und das Montageelement 40 können miteinander mechanisch verbunden sein, was durch die dünnen strichpunktierten Linien 45 angedeutet ist.

Die Drückeinrichtung 42 weist ein Kissenelement 54 aus einem elektrisch isolierenden und elastisch nachgiebigen Material auf. Damit es durch das Kissenelemen4t 54 auch bei hohen Betriebs- bzw. Anwendungstemperaturen der Schaltungsanordnung 10 infolge Fließens des Materials des Kissenelementes 54 nicht zu einer Abnahme des Anpreßdruckes der Drückeinrichtung 42 gegen die Trägerplatte 14 bzw. das Kühlbauteil 12 kommt, ist das Kissenelement 54 an bestimmten gegen das zu kühlende Bauelement 20 bzw. gegen die Trägerplatte 14 drückenden, durch Erhebungen 62 gebildeten Abschnitten von einem zugehörigen Brückenelement 74 umgeben bzw. begrenzt, das aus einem im Vergleich zum Material des Kissenelementes 54 wärme- und formstabilen Material besteht. Das/jedes Brückenelement 74 kann aus einem elektrisch isolierenden oder aus einem elektrisch leitenden Material bestehen. Besteht das entsprechende Brückenelement aus elektrisch isolierendem Material, so handelt es sich vorzugsweise um einen aushärtenden Kunststoff. Das Kissenelement 54 kann bspw. aus einem Silikongummi bestehen.

Das/jedes Brückenelement 74 ist vorzugsweise an seiner vom Montageelement 40 abgewandten Unterseite 56 in mindestens annähernder Anpassung an die Höhenprofilierung der Trägerplatte 14, des auf der Trägerplatte 14 angeordneten chipförmigen Bauelementes 20 bzw. der starren Verbindungselemente 36 zwischen der Trägerplatte 14 und dem Substrat 28 mit Ausnehmungen 58, 60 und mit Erhebungen 64 ausgebildet. Die Ausnehmungen 58 dienen zur Aufnahme und Justierung der Trägerplatte 14 und des Substrates 28 in bezug auf das Kühlbauteil 12, während die/jede Ausnehmung 60 zur Aufnahme und Justierung eines zugehörigen starren Verbindungselementes 36 dient. Mit Hilfe der Andrückvorrichtung 38 kann also nicht nur die Trägerplatte 14 mit dem chipförmigen Bauelement 20 sowie das Substrat 28 mit den Anschlüssen 30 und 32 genau passend am Kühlbauteil 12 festgelegt werden, sondern bspw. gleichzeitig mit den starren Verbindungselementen 36 auch der entsprechende elektrisch leitende Kontakt zwischen den Kontaktflächen 16 an der Trägerplatte 14 und bspw. dem Anschluß 32 am Substrat 28 hergestellt werden.

Eine Weichvergußmasse 68 bedeckt das auf den Trägerkörper 14 vorgesehene chipförmige Bauelement 20.

## Patentansprüche

1. Schaltungsanordnung mit mindestens einer Trägerplatte (14), auf welcher mindestens ein zu kühlendes chipförmiges Bauelement (20), insbes. Halbleiterbauelement, und Kontaktflächen (16) vorgesehen sind, wobei das/jedes Bauelement (20) mit zugehörigen Kontaktflächen (16) mittels Verbindungselementen (26) elektrisch leitend verbunden ist, mit einem Kühlbauteil (12), auf welchem die mindestens eine Trägerplatte (14) angeordnet ist, und mit einer Andrückvorrichtung (38), mit welcher die mindestens eine Trägerplatte (14) gegen das Kühlbauteil (12) gedrückt wird,
**dadurch gekennzeichnet,**
daß die Andrückvorrichtung (38) mindestens ein wärme- und formstabiles Montageelement (40) und ein Kissenelement (54) aus einem elektrisch isolierenden, elastisch nachgiebigen Material als Drückeinrichtung (42) aufweist, das auf der dem Kühlbauteil (12) zugewandten Innenseite (44) des Montageelementes (40) vorgesehen ist und das gegen das mindestens eine zu kühlende Bauelement (20) und/oder in dessen Nachbarschaft elektrisch isoliert gegen die mindestens eine Trägerplatte (14) drückt, wobei das Kissenelement (54) an seiner vom Montageelement (40) abgewandten Seite (56) in mindestens annähernder Anpassung an die Profilierung der mindestens einen Trägerplatte (14), des mindestens einen Bauelementes (20) bzw. der Verbindungselemente (36) auf dem Kühlbauteil (12) mit Ausnehmungen (58, 60) und Erhebungen (62, 64, 66) ausgebildet ist, wobei mindestens eine Ausnehmung (58) zur Justierung der zugehörigen Trägerplatte (14) relativ zum Kühlbauteil (12) und Ausnehmungen (60) zur Justierung und zur Fixierung von starren, loslösbaren Verbindungselementen (36) vorgesehen sind.

2. Schaltungsanordnung nach Anspruch 1,
**dadurch gekennzeichnet**,
daß das Kissenelement (54) Erhebungen (62) zum unmittelbaren Andrücken der mindestens einen Trägerplatte (14) bzw. zum Andrücken der mindestens einen Trägerplatte (14) über das mindestens eine an der entsprechenden Trägerplatte (14) angeordnete Bauelement (20) am Kühlbauteil (12) aufweist.

3. Schaltungsanordnung nach Anspruch 1,
**dadurch gekennzeichnet,**
daß das Montageelement (40) auf seiner dem Kühlbauteil (121) zugewandten Innenseite (40) eine Profilierung aufweist, die mindestens annähernd an die Profilierung (56) des mindestens einen Kissenelementes (54) angepaßt ist.

4. Schaltungsanordnung nach einem der vorhergehenden Ansprüche,
**dadurch gekennzeichnet**,
daß das mindestens eine, auf der Trägerplatte (14) angeordnete, zu kühlende Bauelement (20) vollständig mit einer Weichvergußmasse (68) bedeckt ist.

5. Schaltungsanordnung nach einem der vorhergehenden Ansprüche,
**dadurch gekennzeichnet**,
daß das Montageelement (40) mit dem Kühlbauteil (12) mechanisch verbunden ist, wobei die mechanische Verbindung (bei 45) mindestens ein Federelement aufweist.

6. Schaltungsanordnung nach Anspruch 1,
**dadurch gekennzeichnet**,
daß das/jedes Kissenelement (54) von mindestens einem zugehörigen Brückenelement (74) mindestens einseitig begrenzt ist, das aus wärme- und formstabilem Material besteht und mittels Erhebungen (64) auf das mindestens eine zu kühlende Bauelement (20) und/oder gegen die mindestens eine Trägerplatte (14) drückt und diese fixiert.

7. Schaltungsanordnung nach Anspruch 6,
**dadurch gekennzeichnet**,
daß das mindestens eine Brückenelement (74) gegen ein Anschlüsse (30, 32) aufweisendes substrat (28) bzw. gegen mindestens ein Substrat (28) mit der Trägerplatte (14) verbindendes Verbindungselement (36) drückt.

8. Schaltungsanordnung nach Anspruch 6 oder 7,
**dadurch gekennzeichnet**,
daß das/jedes Brückenelement (74) aus einem elektrisch isolierenden Material besteht.

9. Schaltungsanordnung nach Anspruch 6 oder 7,
**dadurch gekennzeichnet,**
daß zumindest einige der Brückenelemente (74) aus einem elektrisch leitenden Material bestehen.

10. Schaltungsanordnung nach einem der Ansprüche 6 bis 9,
**dadurch gekennzeichnet,**
daß die Brückenelemente (74) als voneinander unabhängige, getrennte Elemente ausgebildet sind.

11. Schaltungsanordnung nach einem der Ansprüche 6 bis 9,
**dadurch gekennzeichnet,**
daß die Brückenelemente (74) miteinander mittels flexibel nachgiebiger Verbindungsorgane zu einer Einheit verbunden sind.

12. Schaltungsanordnung nach einem der Ansprüche 6 bis 11,
**dadurch gekennzeichnet,**
daß mindestens eines der Brückenelemente (74) an seiner dem Kühlbauteil (12) zugewandten Unterseite (56) mit einer an die Profilierung der mindestens einen Trägerplatte (14), des mindestens einen Bauelementes (20) bzw. der Verbindungselemente (36) angepaßten Oberflächenkontur bzw. mit entsprechenden Einsenkungen (58, 60) und Erhebungen (62, 64) ausgebildet ist.

## Revendications

1. Dispositif de circuit comportant au moins une plaque porteuse (14), sur laquelle au moins un composant (20), en forme de puce, à refroidir, notamment un composant semi-conducteur, et des surfaces de contact (16) sont prévus, ledit/ou chaque composant (20) étant lié électriquement à des surfaces de contact (16) respectives au moyen d'éléments de liaison (26), comportant un composant réfrigérant (12), sur lequel est placée ladite au moins une plaque porteuse (14), et comportant un moyen d'application (38), avec lequel ladite au moins une plaque porteuse (14) est appuyée contre ledit composant réfrigérant (12), caractérisé en ce que
- ledit moyen d'application (38) comporte au moins un élément de montage (40) offrant une stabilité thermique et de forme, et un élément coussin (54) en un matériau électriquement isolant, élastiquement déformable en tant qu'organe presseur (42),
- lequel est prévu sur la face intérieure (44) dudit élément de montage (40) tournée vers ledit composant réfrigérant (12) et appuie contre ledit au moins un composant (20), à refroidir, et/ou dans le voisinage dudit composant à refroidir, contre ladite au moins une plaque porteuse (14) de manière électriquement isolée,
- ledit élément coussin (54) étant conformé avec des évidements (58,60) et des saillies (62,64,66) sur sa face (56) écartée dudit élément de montage(40), dans une adaptation au moins approximative au profil de ladite au moins une plaque porteuse (14), dudit au moins un composant (20) ou des éléments de liaison (36) sur ledit composant réfrigérant (12),
- où au moins un évidement (58) est prévu pour l'ajustage de ladite plaque porteuse (14) respective en rapport avec ledit composant réfrigérant (12) et des évidements (60) sont prévus pour l'ajustage et la fixation d'éléments de liaison (36) rigides et détachables.

2. Dispositif de circuit selon la revendication 1, caractérisé en ce que ledit élément coussin (54) comporte des saillies (62) pour appuyer directement ladite au moins une plaque porteuse (14) ou pour appuyer ladite au moins une plaque porteuse (14) via ledit au moins un composant (20), placé sur ladite plaque porteuse (14) correspondante, sur ledit composant réfrigérant (12).

3. Dispositif de circuit selon la revendication 1, caractérisé en ce que ledit élément de montage (40) comporte sur sa face intérieure (40), tournée vers ledit composant réfrigérant (12), un profil adapté au moins approximativement au profil (56) dudit au moins un élément coussin (54).

4. Dispositif de circuit selon l'une des revendications précédentes, caractérisé en ce que ledit au moins un composant (20), à refroidir, placé sur ladite plaque porteuse (14), est recouvert entièrement d'une masse moelleuse de remplissage (68).

5. Dispositif de circuit selon l'une des revendications précédentes, caractérisé en ce que ledit élément de montage (40) est lié mécaniquement audit composant réfrigérant (12), la liaison mécanique (45) comportant au moins un élément ressort.

6. Dispositif de circuit selon la revendication 1, caractérisé en ce que ledit/chaque élément coussin (54) est limité au moins d'un côté par au moins un élément pont (74) respectif, ledit élément coussin étant constitué d'un matériau offrant une stabilité thermique et une stabilité de forme et prenant appui au moyen de saillies (64) sur ledit au moins un composant (20), à refroidir, et/ou contre ladite au moins une plaque porteuse (14) en fixant ces éléments.

7. Dispositif de circuit selon la revendication 6, caractérisé en ce que ledit au moins un élément pont (74) appuie contre un substrat (28) présentant des raccordements (30, 32) ou contre un élément de liaison (36) reliant au moins un substrat (28) avec la plaque porteuse (14).

8. Dispositif de circuit selon la revendication 6 ou 7, caractérisé en ce que ledit/chaque élément pont (74) est constitué d'un matériau électriquement isolant.

9. Dispositif de circuit selon la revendication 6 ou 7, caractérisé en ce qu'au moins quelques-uns desdits composants pont (74) sont constitués d'un matériau électriquement conducteur.

10. Dispositif de circuit selon l'une des revendications 6 à 9, caractérisé en ce que lesdits composants pont (74) sont formés en tant qu'éléments séparés, indépendants les uns des autres.

11. Dispositif de circuit selon l'une des revendications 6 à 9, caractérisé en ce que lesdits composants pont (74) sont réunis les uns aux autres en une unité, au moyen d'organes de liaison déformables de manière flexible.

12. Dispositif de circuit selon l'une des revendications 6 à 11, caractérisé en ce qu'au moins un desdits éléments pont (74) est formé sur sa face inférieure (56), tournée vers le composant réfrigérant (12), avec un contour de surface adapté au profilage de ladite au moins une plaque porteuse (14) dudit au moins un composant (20), ou avec un contour superficiel adapté aux éléments de liaison (36), avec des évidements (58,60) et des saillies (62,64) correspondantes.

## Claims

1. Switching arrangement with at least one carrier plate (14), on which at least one to-be-cooled chip-shaped component (20), especially a semiconductor component, and contact areas (16) are provided, wherein the/each component (20) is electrically connected with respective contact areas (16) by means of connecting elements (26), with a cooling component part (12), on which the at least one carrier plate (14) is arranged, and with a pressure device (38), by which the at least one carrier plate (14) is pressed against the cooling component part (12), characterized in that the pressure device (38) comprises at least one heat resistant and shape-retaining mounting element (40) and a cushion element (54) of an electrically insulating, elastically resilient material as a pressurizing means (42), which is provided on the inner side (44) of the mounting element (40) facing the cooling component part (12) and which presses in an electrically insulating way against the at least one to-be-cooled component (20) and/or in the neighborhood thereof presses against the at least one carrier plate (14), wherein the cushion element (54) is provided on its side (56) facing away from the mounting element (40) with recesses (58, 60) and projections (62, 64, 66) respectively corresponding, at least approximately, to the profiles of the at least one carrier plate (14) of the at least one component (20) and of the connecting elements (36) on the cooling component part (12), whereby at least one recess (58) is provided for aligning the respective carrier plate (14) relative to the cooling component part (12) and other of said recesses (60) are provided for aligning and for fixing the rigid, removable connecting elements (36).

2. Switching arrangement according to claim 1, characterized in that the cushion element (54) comprises projections (62) respectively for immediately pressing on the at least one carrier plate (14) and for pressing on the at least one carrier plate (14) via the at least one component (20) on the corresponding carrier plate (14) on the cooling component part (12).

3. Switching arrangement according to claim 1, characterized in that the mounting element (40) has a profile on its inner side (40) facing the cooling component part (12), which is adapted at least approximately to the profile (56) of the at least one cushion element (54).

4. Switching arrangement according to any one of the preceding claims, characterized in that the at least one to-be-cooled component (20) arranged on the carrier plate (14) is completely covered with a soft moulded mass (68).

5. Switching arrangement according to any one of the preceding claims, characterized in that the mounting element (40) is mechanically connected with the cooling component part (12), wherein the mechanical connection (at 45) comprises at least one resilient element.

6. Switching arrangement according to claim 1, characterized in that the/each cushion element (54) is bordered on at least one side by at least one corresponding bridging element (74), which is composed of heat resistant and shape-retaining material and which presses by means of projections (64) on the at least one to-be-cooled component (20) and/or against the at least one carrier plate (14) and fixes these.

7. Switching arrangement according to claim 6, characterized in that the at least one bridging element (74) respectively presses against a substrate (28) providing connections (30, 32) and against at least one connecting element (36) connecting the substrate (28) with the carrier plate (14).

8. Switching arrangement according to claim 6 or claim 7, characterized in that the/each bridging element (74) is composed of an electrically insulating material.

9. Switching arrangement according to claim 6 or claim 7, characterized in that at least some of the bridging elements (74) are composed of an electrically conducting material.

10. Switching arrangement according to any one of claims 6 to 9, characterized in that the bridging elements (74) are provided as independent elements separate from each other.

11. Switching arrangement according to any one of claims 6 to 9, characterized in that the bridging elements (74) are connected into a unified whole by means of flexible, resilient connecting means.

12. Switching arrangement according to any one of claims 6 to 11, characterized in that at least one of the bridging elements (74) is provided on its underside facing the cooling component part (12) with an upper surface contour with recesses (58, 60) and projections (62, 64) respectively corresponding to the profile of the at least one carrier plate (14), of the at least one component (20) and of the connecting elements (36).
